(19) Europäisches Patentamt
European Patent Office
Office européen des brevets

(11) **EP 4 542 817 A1**

(12) **EUROPEAN PATENT APPLICATION**
published in accordance with Art. 153(4) EPC

(43) Date of publication:
**23.04.2025 Bulletin 2025/17**

(21) Application number: **23872943.8**

(22) Date of filing: **21.09.2023**

(51) International Patent Classification (IPC):
*H02J 7/00* (2006.01)        *G01R 31/382* (2019.01)
*G01R 31/392* (2019.01)        *H01M 10/44* (2006.01)

(52) Cooperative Patent Classification (CPC):
**G01R 31/382; G01R 31/392; H01M 10/44;**
**H02J 7/00**

(86) International application number:
**PCT/KR2023/014363**

(87) International publication number:
**WO 2024/071826 (04.04.2024 Gazette 2024/14)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority:  **28.09.2022  KR 20220123691**
**24.10.2022  KR 20220137593**

(71) Applicant: **Samsung Electronics Co., Ltd.**
**Suwon-si, Gyeonggi-do 16677 (KR)**

(72) Inventors:
• **LEE, Sangheon**
**Suwon-si, Gyeonggi-do 16677 (KR)**
• **KIM, Youngju**
**Suwon-si, Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(54) **METHOD AND ELECTRONIC DEVICE FOR CHARGING BATTERY**

(57)     An electronic device may include a battery, a memory, and a processor operatively coupled to the battery and the memory. The processor may be configured for a first charging pattern as the main charging pattern. The processor may obtain data related to charging of the battery in a situation in which the battery is charged based on the main charging pattern. The processor may identify a first life expectancy based on the configured first charging pattern and the obtained data. The processor may identify a second charging pattern that satisfies a second life expectancy relatively longer than the identified first life expectancy. The processor may change the main charging pattern from the first charging pattern to the second charging pattern. The processor may determine a charging current corresponding to the charging voltage of the battery based on the second charging pattern in response to the charge request signal for the battery. Other various embodiments may be possible.

FIG. 4

```
START
  ↓
CONFIGURING FIRST CHARGING PATTERN AMONG A PLURALITY OF
CHARGING PATTERNS                                            — 401
  ↓
OBTAINING DATA RELATED TO CHARGING OF BATTERY               — 403
  ↓
IDENTIFYING FIRST CHARGING TIME AND FIRST LIFE EXPECTANCY OF
BATTERY BASED ON CONFIGURED FIRST CHARGING PATTERN AND OBTAINED DATA  — 405
  ↓
IDENTIFYING N-TH CHARGING TIME AND N-TH LIFE EXPECTANCY
CORRESPONDING TO EACH OF PLURALITY OF CHARGING PATTERNS      — 407
  ↓
DETERMINING SECOND CHARGING PATTERN AMONG PLURALITY OF CHARGING
PATTERNS BASED ON IDENTIFIED N-TH CHARGING TIME AND LIFE EXPECTANCY  — 409
  ↓
DETERMINING CHARGING CURRENT CORRESPONDING TO CHARGING VOLTAGE BASED
ON SECOND CHARGING PATTERN IN RESPONSE TO BATTERY CHARGING
REQUEST SIGNAL                                               — 411
  ↓
END
```

EP 4 542 817 A1

**Description**

[Technical Field]

Certain example embodiments relate to methods and/or electronic devices for charging batteries.

[Background Art]

Recently, various types of portable electronic devices (e.g., a smart phone, a tablet PC, a portable multimedia player (PMP), a personal digital assistant (PDA), a laptop personal computer (PC), a wrist watch, and/or a head-mounted display (HMD)) have been emerging. Portable electronic devices may include wearable devices that can be worn at least partially on the human body.

Portable electronic devices have been developed to perform various functions and the processor became to consume a lot of current. Portable electronic devices require a high-performance battery. Among high-performance batteries, the lithium ion battery (LIB) has been used extensively because it has advantages of a high energy density, a high discharge voltage, or output stability.

The foregoing information may be provided as background technology for the purpose of assisting in the understanding of the present disclosure. No claim or determination is made as to whether any of the foregoing may be applied as prior art in connection with the present disclosure.

[Disclosure of Invention]

[Technical Problem]

In the case of charging the battery, the higher power (e.g., voltage and/or current) supplied to the battery is configured, the shorter time is required to fully charge the battery. However, the higher voltage and current supplied to the battery is configured, the more the deterioration phenomenon is accelerated and the more quickly the battery use life is shortened.

Conversely, in the case of charging the battery, if the power (e.g., voltage and/or current) supplied to the battery is configured low, it may take a long time to fully charge, but the battery use life may be relatively long.

According to an example embodiment, the purpose of the electronic device is to select an optimal charging pattern that minimizes or reduces a loss of charging time and/or reduces battery performance deterioration among a plurality of charging patterns for charging a battery.

Technical problems to be solved are not limited to the aforementioned technical problems, and other technical problems not described above may be easily understood from the following description by a person having ordinary knowledge in the art.

[Solution to Problem]

According to an example embodiment, the electronic device may include a battery, a memory, and a processor operatively coupled to the battery and the memory. The processor may configure a first charging pattern as the main charging pattern. The processor may obtain data related to charging of the battery in a situation in which the battery is charged based on the main charging pattern. The processor may identify a first life expectancy based on the configured first charging pattern and the obtained data. The processor may identify a second charging pattern that satisfies a second life expectancy relatively longer than the identified first life expectancy. The processor may change a main charging pattern from the first charging pattern to the second charging pattern. The processor may determine a charging current corresponding to the charging voltage of the battery based on the second charging pattern in response to the charge request signal for the battery.

An example method for charging a battery according to an example embodiment may include an operation of configuring the first charging pattern as the main charging pattern; an operation of obtaining the data related to charging the battery in a situation in which the battery is charged based on the main charging pattern; an operation of identifying a first life expectancy based on the configured first charging pattern and the obtained data; an operation of identifying a second charging pattern that satisfies a second life expectancy that is relatively longer than the identified first life expectancy; an operation of changing a main charging pattern from the first charging pattern to the second charging pattern; and an operation of determining a charging current corresponding to the charging voltage of the battery based on the second charging pattern in response to the charge request signal for the battery.

According to an example embodiment, a non-temporary computer-readable storage medium storing one or more programs (or a computer program product) can be described. According to an example embodiment, one or more programs, when executed by the processor of the electronic device, may include instructions for performing an operation of configuring the first charging pattern as the main charging pattern; an operation of obtaining the data related to charging the battery in a situation in which the battery is charged based on the main charging pattern; an operation of identifying a first life expectancy based on the configured first charging pattern and the obtained data; an operation of identifying a second charging pattern that satisfies a second life expectancy that is relatively longer than the identified first life expectancy; an operation of changing a main charging pattern from the first charging pattern to the second charging pattern; and an operation of determining a charging current corresponding to the charging voltage of the battery based on the second charging pattern in response to the charge request signal for the battery.

[Advantageous Effects of Invention]

In an example embodiment, the electronic device may consider the information (e.g., an average current, an average voltage, an average temperature, a capacity loss history in the case of charging or discharging) related to the use of the battery. There may be a plurality of charging patterns in charging the battery. According to an example embodiment, the electronic device may select an optimized charging pattern among a plurality of charging patterns based on information related to the use of the battery, and it may charge the battery using the selected charging pattern.

In an example embodiment, the electronic device may store a charging pattern map composed of a plurality of charging patterns in a memory and update the charging pattern map at every predetermined interval. In an example embodiment, the electronic device may select an optimal charging pattern for improving battery lifespan based on the current state. An electronic device may charge efficiently the battery based on an optimal charging pattern. According to an example embodiment, the battery lifespan may be improved by using the optimal charging pattern.

Effects obtainable in the present disclosure are not limited to the aforementioned effects, and other effects not mentioned may be easily understood from the following description by a person having ordinary knowledge in the art to which the disclosure pertains.

[Brief Description of Drawings]

The above and other aspects, features and advantages of certain embodiments of the present disclosure will be more apparent from the following detailed description, taken in conjunction with the accompanying drawings, in which:

In connection with the description of the drawings, the same or similar reference numerals may be used for the same or similar elements.

FIG. 1 is a block diagram of an electronic device in a network environment according to an example embodiment.
FIG. 2 is a block diagram of a power management module and a battery according to an example embodiment.
FIG. 3 is a block diagram of an electronic device according to an example embodiment.
FIG. 4 is a flowchart illustrating a method of determining a charging pattern among a plurality of charging patterns according to an example embodiment.
FIG. 5 is a flowchart illustrating a method of updating a charging pattern map for selecting an optimal charging pattern according to an example embodiment.
FIG. 6A is an exemplary diagram illustrating a first embodiment in which a charging pattern is determined among the plurality of charging patterns according to an example embodiment.
FIG. 6B is an exemplary diagram illustrating a second embodiment in which a charging pattern is determined among the plurality of charging patterns according to an example embodiment.

[Mode for the Invention]

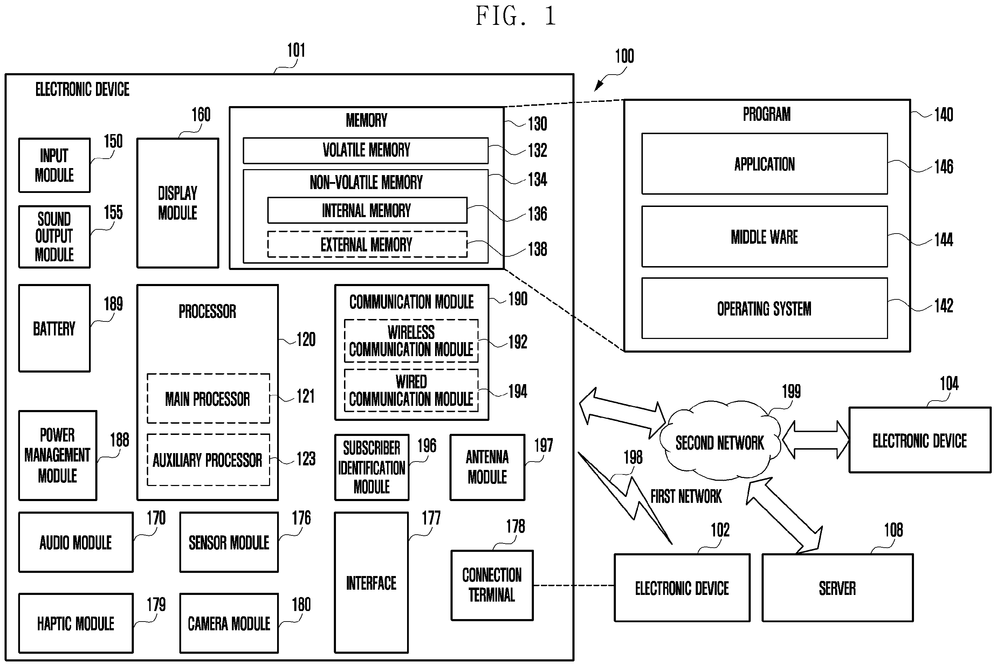

Fig. 1 is a block diagram illustrating an example electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connection/connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190 comprising communication circuitry) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band. For example, the plurality of antennas may include a patch array antenna and/or a dipole array antenna.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

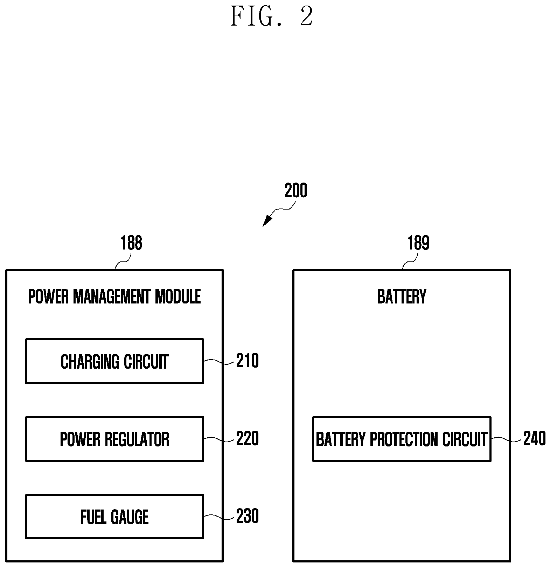

FIG. 2 is a block diagram of a power management module and a battery according to an example embodiment.

FIG. 2 is a block diagram 200 of a power management module (e.g., power management module 188 in FIG. 1) and a battery (e.g., battery 189 in FIG. 1), in accordance with various embodiments. With reference to FIG. 2, the power management module 188 may include a charging circuit 210, a power regulator 220, or a fuel gauge 230. The charging circuit 210 may charge the battery 189 using power supplied from an external power source for the electronic device 101. According to an embodiment, the charging circuit 210 may select a charging method (e.g., normal charging or rapid charging) based on at least a portion of a type of external power source (e.g., a power adapter, USB, or wireless charging), a size of power supplied from the external power source (e.g., about 20 watts or more), or the properties of the battery 189, and it may charge the battery 189 using the selected charging method. The external power source, for example, may be wired through a connection terminal (e.g., the connection terminal 178 of FIG. 1) or wirelessly through an antenna module (e.g., the antenna module 197 of FIG. 1, comprising at least one antenna).

According to an embodiment, the power regulator 220 may generate a plurality of powers having different voltages or current levels by adjusting a voltage level or a current level of power supplied from an external power source or the battery 189. The power regulator 220 may adjust the power of the external power source or battery 189 to a voltage or current level suitable for each component of the components included in the electronic device 101. According to an embodiment, the power regulator 220 may be implemented in the form of a low drop out (LDO) regulator or a switching regulator.

The fuel gauge 230 may measure usage state information (e.g., battery capacity, number of charge/discharge cycles, voltage, or temperature) of the battery 189.

The power management module 188, comprising circuitry, for example, may determine a charging state information (e.g., a lifespan, an overvoltage, an undervoltage, an overcurrent, an overcharge, over discharge, overheating, short circuit, or swelling) related to the charging of the battery 189 based at least in part on the measured use state information using the charging circuit 210, the voltage regulator 220, or the fuel gauge 230. The power management module 188 may determine whether the battery 189 is in an abnormal state or a normal state based at least in part on the determined state of charge information, and then it may adjust the charging of the battery 189 if it is determined to be in an abnormal state (e.g., reducing the charging current or voltage, or stopping charging). According to an embodiment, at least a portion of the functions of the power management module 188 may be performed by an external control device (e.g., the processor 120 of FIG. 1).

The battery 189 may include, for example, a battery protection circuit module (PCM) 240. The battery protection circuit module 240 may perform various functions (e.g., a preblocking function) to prevent or reduce deterioration or burnout of the battery 189. The battery protection circuit module 240, comprising circuitry, may be configured as at least a portion of a battery management system (BMS) additionally or in alternative to for performing a cell balancing, a battery capacity measurement, a charge/discharge count measurement, a temperature measurement, or a voltage measurement.

According to an embodiment, at least a portion of the information on the state of use or the state of charge of the battery 189 may be measured using the corresponding sensor (e.g., a temperature sensor) among the fuel gauge sensor 230, the power management module 188, or the sensor module 176. In this case, according to an embodiment, the corresponding sensor (e.g., temperature sensor) of the sensor module 176 may be included as part of the battery protection circuit module 240 or may be disposed near the batter 189 as a separate device.

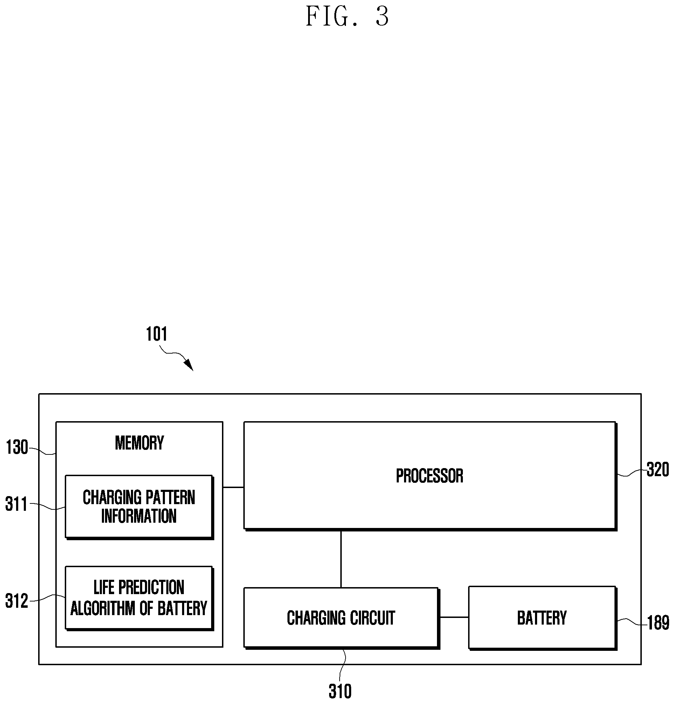

FIG. 3 is a block diagram of an electronic device according to an example embodiment.

The electronic device 101 of FIG. 3 may be at least partially similar to the electronic device 101 of FIG. 1 or may further include other embodiments of the electronic device 101.

With reference to FIG. 3, the electronic device (e.g., the electronic device 101 in FIG. 1) may include a processor 320 (e.g., the processor 120 of FIG. 1), a memory (e.g., the memory 130 of FIG. 1), a charging circuit 310, and/or a battery (e.g., the battery 189 of FIG. 1). The memory 130 may store charging pattern information 311 and a life prediction algorithm 312 of the battery. According to an embodiment, the electronic device 101 may select a charging pattern from a plurality of charging patterns based on the charging pattern information 311 and the life prediction algorithm 312 for the battery stored in the memory 130. The electronic device 101 may determine the charging current corresponding to the charging voltage associated with charging battery 189 based on the selected charging pattern. Each "processor" herein comprises processing circuitry.

According to an embodiment, the processor 320 of the electronic device 101 may control other configuration elements (e.g., the hardware and/or software components) of the electronic device 101 and/or the external electronic device 102 and perform various data processing and/or calculation by executing a program (e.g., the program 140 of FIG. 1) stored in the memory 130. According to an embodiment, the processor 120/320 may include a control circuit of the power management module (e.g., the power management module 188 of FIG. 1, such as including a power management integrated circuit (PMIC)) that supplies power to the electronic device 101. According to an embodiment, the processor 120/320 may be connected operatively, functionally, and/or electrically to a memory 130, a charging circuit 310, and/or a battery 189.

According to an embodiment, the charging pattern information 311 including a plurality of charging patterns related to charging of the battery 189 may be stored in the memory 130. For example, the charging pattern may include a multi-step constant-current constant-voltage pattern. According to an embodiment, the processor 120/320 may select a charging pattern at least partially among all types of charging patterns associated with charging battery 189 and store the selected charging pattern as charging pattern information 311. For example, in charging the battery 189, the charging pattern information 311 may configure operating voltage ranges ($V_{min}$, $V_{max}$) and operating current ranges ($I_{min}$, $I_{max}$) and include an operating current value corresponding to a specific operating voltage value. For example, the operating voltage range may be divided evenly into the first interval and be configured as "$\{V_i\}_{i<n}$" and the operating current range may be divided evenly into the second interval and be configured as "$\{I_j\}_{j<m}$". In an embodiment, in the charging pattern information 311, interval set (e.g., $\{intv_i\}_{i<n} = \{(V_0, V_1), ..., (V_{n-2}, V_{n-1})\}$) may be determined based on "$\{V_i\}_{i<n}$" and "$\{I_j\}_{j<m}$" and the charging current value corresponding to each interval (e.g., $intv_i$) may be determined. According to an embodiment, in the charging pattern information 311 a first charging current value included in the operating current range may be configured based on the first charging voltage included in the operating voltage range. The charging pattern information 311 may include the information related to the first charging current determined in response to the first charging voltage supplied by each unit charging voltage as the first charging voltage is supplied to the battery 189 by each unit charging voltage. According to an embodiment, the operating voltage range and operating current range are not limited to being equally divided, but they may be divided unevenly. According to an embodiment, the electronic device 101 may divide the unit charging voltage additionally and determine the charging voltage supplied by the additionally segmented interval and the charging current corresponding to the charging voltage.

According to an embodiment, the electronic device 101 may select a charging pattern that satisfies a predetermined condition among all types of charging patterns (e.g., $(n-1)^m$) associated with charging of the battery 189 and store the selected charging pattern in the memory 130 as charging pattern information 311. For example, the predetermined condition may include a condition satisfying an equivalent circuit model. The equivalent circuit model may include a form in which a resistor $R_0$ is connected, directly or indirectly, to a functional voltage source providing an electromotive force of a function $V_{OC}$. For example, the function of electromotive force (e.g., $V_{OC}$) for depth of charge may include a built-in function that appropriately interpolates experimentally specific data by a spline method. For example, resistance $R_0$ may include a measured value of direct current internal resistance (DCIR) of the battery in its initial state. The resistance $R_0$ may include a predetermined initial resistance. For example, the pouch type lithium ion battery may have a resistance $R_0$ of

about 0.03 to about 0.07 Ohm.

According to an embodiment, the electronic device 101 may reflect a function (e.g., $V_{OC}$) and a resistance ($R_0$) (e.g., the initial resistance) related to all types of charging patterns (e.g., $(n-1)^m$) and select at least one charging pattern. According to an embodiment, the electronic device 101 may configure the upper limit data $t_{max}$ of the charging time of the battery 189. For example, the upper limit data of the charging time may be decided by the developer arbitrarily, or data input by the user may be included, to ensure easy usability of the battery 189. According to an embodiment, the electronic device 101, for all types of charging patterns (e.g., $(n-1)^m$), may reflect the following Equation 1 and identify the "$t_{end}$" value.

[ Equation 1]

$$\underset{t_{end}}{\arg\min}\left| V_{OC}\left(\int_0^{t_{end}}\frac{I(t)}{Q_0}dt\right) + I(t_{end})R_0 - V_{cutoff}\right| < t_{max}$$

For example, if the first charging pattern among all types of charging patterns can be applied to Equation 1 and the "$t_{end}$" value can be identified, the first charging pattern may be included in the charging pattern information 311. For example, the first charging pattern may indicate a charging pattern that improves the lifespan of the battery 189.

According to an embodiment, in the electronic device 101, as the cycle related to charging and/or discharging of the battery 189 increases, R (cycle) may be decided where the internal resistance (e.g., ($R_0$)) increases. $R_0$ included in the above Equation 1 may be changed to R (cycle) and may calculate $t_{end}$ (cycle) value by being changed to Equation 2 below. For example, it is assumed that among all types of charging patterns, the first charging pattern is applied to Equation 2.

[ Equation 2]

$$t_{end}(cycle) = \underset{t_{end}}{\arg\min}\left| V_{OC}\left(\int_0^{t_{end}}\frac{I(t)}{Q_0}dt\right) + I(t_{end})R(cycle) - V_{cutoff}\right|$$

According to an embodiment, $t_{end}$ (cycle) value may be applied to Equation 3 below, and Q(cycle), which is the capacity level of the battery 189 in a specific cycle, may be calculated. $Q_0$ of Equation 3 may indicate the maximum capacity of the battery 189, or it may be a predetermined value.

[Equation 3]

$$Q(cycle) = \int_0^{t_{end}(cycle)}\frac{I(t)}{Q_0}dt$$

According to an embodiment, Q(cycle) calculated in Equation 3 may be applied to Equation 4 below. In Equation 4, the failure capacity ratio $Q_{min}$ and the $cycle_{max}$ value, which is the maximum physically allowable cycle value, may be configured in advance. For example, the failure capacity ratio ($Q_{min} = Q_0 *$ ratio) may indicate a capacity ratio of the battery 189 in which the battery 189 is determined to be unusable based on the maximum capacity $Q_0$ of the battery 189. The failure capacity ratio may include a ratio value for determining failure of the battery 189, and it may be configured in advance by the developer. For example, if the "ratio" value is 0.8 (e.g., about 80%), the failure capacity ratio $Q_{min}$ may indicate a capacity ratio of 80% to the maximum capacity of the battery 189. When the capacity of the battery 189 is lowered to less than about 80%, the corresponding battery 189 may be determined as an unusable battery. According to an embodiment, if the maximum capacity of the battery 189 is predicted to exceed the failure capacity ratio at the time when the number of cycles associated with charging of the battery 189 exceeds the configured number of cycles, a charging pattern applied to the battery 189 may be included in the charging pattern information 311. A charging pattern included in the charging pattern information 311 may indicate a charging pattern in which the charging efficiency of the battery is relatively excellent.

[ Equation 4]

$$\underset{cycle}{\arg\max}|Q_{min} - Q(cycle)| > cycle_{max}$$

According to an embodiment, when Q(cycle) calculated in Equation 3 satisfies Equation 4, the first charging pattern applied in Equation 2 may be included in the charging pattern information 311. According to an embodiment, the electronic device 101 may apply Equation 1 to Equation 4 in relation to all types of charging patterns (e.g., $(n-1)^m$) and identify at least one charging pattern satisfying Equation 4. The electronic device 101 may store at least one identified charging pattern in the memory 130 as charging pattern information 311.

According to an embodiment, a life prediction algorithm 312 for predicting the life of the battery 189 may be stored in the memory 130. For example, the electronic device 101 may identify data (e.g., an average current, an average voltage, an average temperature, and/or a capacity loss history in the charging operation and discharging operation of the battery 189) related to charging of the battery 189. The electronic device 101 may reflect the identified data related to charging of the identified battery 189 in the life prediction algorithm 312 and identify the life expectancy (e.g., the life expectancy, L value) and the charging time (e.g., t value) of the battery 189. According to an embodiment, the electronic device 101 may apply at least one charging pattern included in the charging pattern information 311 to the life prediction algorithm 312 and identify the life expectancy (e.g., the life expectancy, L value) and the charging time (e.g., t value) corresponding to the charging pattern.

According to an embodiment, the electronic device 101 may identify the life expectancy (e.g., L value) and the charging time (e.g., t value) of the battery 189 using the Bayesian estimation method. For example, the Bayesian estimation method may be a method of calculating the distribution of all possibilities that a parameter value may have. The processor 120/320 of the electronic device 101 may identify the life expectancy and the charging time corresponding each of all charging patterns included in the charging pattern information 311 based on the Bayesian estimation method. Bayesian estimation may predict the posterior distribution over discrete domains using prior measurement data (e.g., at least one charging pattern included in the charging pattern information 311). According to an embodiment, the electronic device 101 may identify or predict a plurality of charging patterns included in the charging pattern information 311, and a life expectancy and a charging time corresponding to each charging pattern based on the Bayesian estimation method.

For example, at least one charging pattern C included in the charging pattern information 311 may be mapped as an ordered pair in a 2n-dimentional space as shown in Equation 5 below. A corresponding charging pattern may indicate $x_c$.

[ Equation 5]

$$x_c = (V_0, \ldots, V_{n-1}, I_0, \ldots, I_{n-1})$$

For example, if the 2n-dimensional mapping of the first charging pattern among the charging patterns included in the charging pattern information 311 is $x_1$, in the case that this is applied to the life prediction algorithm 312 for the battery, an ordered pair of life expectancy and charging time $y_1 = (L_0, t_0)$ may be identified. According to an embodiment, the electronic device 101 may apply the life prediction algorithm 312 corresponding to each of the charging patterns included in the charging pattern information 311 and identify or predict the set y related to the life expectancy and the charging time. For example, set y may be configured of an ordered pair based on the life expectancy L and the charging time t. According to an embodiment, the electronic device 101 may generate a "charging time-life expectancy map" corresponding to a plurality of charging patterns based on a set y (e.g., a ordered pair (L,t)) and store the "charging time-life expectancy map" in the memory 130.

According to an embodiment, the life prediction algorithm 312 may include an algorithm for predicting a life expectancy and a charging time corresponding to the charging pattern (e.g., at least one charging pattern included in the charging pattern information 311) using Equation 6 to Equation 10 below.

[ Equation 6]

$$\hat{x} = x \cap x_0{}^c$$

[ Equation 7]

$$K(z_1, z_2) = \begin{bmatrix} k(z_{11}, z_{21}) & k(z_{11}, z_{22}) & \ldots & k(z_{11}, z_{22}) \\ k(z_{12}, z_{21}) & \ddots & & \vdots \\ \vdots & & \ddots & \vdots \\ k(z_{1n}, z_{21}) & \ldots & \ldots & k(z_{1n}, z_{2m}) \end{bmatrix}$$

[ Equation 8]

$$\begin{bmatrix} y_0 \\ y \end{bmatrix} = N\left(\begin{bmatrix} \mu_0 \\ \mu \end{bmatrix}, \begin{bmatrix} K(x_0, x_0) + \sigma_n^2 & K(x_0, \hat{x}) \\ K(\hat{x}, x_0) & K(\hat{x}, \hat{x}) \end{bmatrix}\right) = N\left(\begin{bmatrix} \mu_0 \\ \mu \end{bmatrix}, \begin{bmatrix} A & B^T \\ B & C \end{bmatrix}\right)$$

[ Equation 9]

$$\mu = B A^{-1} \mu_0$$

[ Equation 10]

$$\sigma_f = C - B A^{-1} B^T$$

With reference to Equation 6 to Equation 10 described above, a plurality of ordered pairs (L, t) composed of the life expectancy (L) and the charging time (t) corresponding to each of the charging patterns (e.g., at least one charging pattern included in the charging pattern information 311) included in set x may be calculated. For example, a plurality of ordered pairs (L, t) may be calculated in the form of a multivariate normal distribution. For example, the average vector based on a plurality of ordered pairs (L, t) may be calculated by Equation 9 and the covariance matrix (e.g., the covariance between variables expressed in matrix form) may be calculated by Equation 10. According to an embodiment, the electronic device 101 may determine a charging pattern that improves the lifespan of the battery 189 based on the mean vector and the covariance matrix.

According to an embodiment, the electronic device 101 may generate a "charging time-life expectancy map" corresponding to a plurality of charging patterns based on a plurality of ordered pairs (L, t). For example, the electronic device 101 may update the "charging time-life expectancy map" in the case that the "charging time-life expectancy map" is stored in the memory 130.

According to an embodiment, the electronic device 101 may determine a charging pattern of which the charging time is less than the predetermined threshold and the life expectancy is high based on the "charging time-life expectancy map". According to an embodiment, the electronic device 101 may charge efficiently the battery 189 based on the determined charging pattern and improve relatively the lifespan of the battery 189.

According to an embodiment, the processor 120/320 may supply a charging voltage and a charging current to the battery 189 through the charging circuit 310 based on the charging pattern included in the charging pattern information 311. For example, the processor 120/320 of the electronic device 101 may identify the charging voltage supplied to the battery 189 based on the charging pattern and determine a charging current corresponding to the identified charging voltage. The processor 120/320 may determine a charging voltage and a charging current corresponding to the charging voltage of the battery 189 for each unit charging voltage. For example, the processor 120/320 may supply a first charging current corresponding to the first charging voltage and a second charging current corresponding to the second charging voltage to the battery 189 based on the charging pattern. **In an** embodiment, the charging pattern may include a method of supplying a specific charging current value to the battery 189 in response to a specific charging voltage value for each unit charging voltage.

According to an embodiment, the processor 120/320 of the electronic device 101 may configure the first charging pattern as the main charging pattern among a plurality of charging patterns included in the charging pattern information 311. For example, the processor 120/320 may charge the battery 189 based on a configured main charging pattern. The processor 120/320 may obtain data (e.g., an average current, an average voltage, an average temperature, and/or a capacity loss history in the charging operation and discharging operation of the battery 189) related to the charging of the battery 189. The processor 120/320 may determine the first charging pattern (e.g., the main charging pattern) and the second charging pattern based on the obtained data among a plurality charging patterns included in the charging pattern information 311. For example, the processor 120/320 may identify the second charging pattern having a relatively shorter charging time than the first charging pattern and a relatively longer life expectancy than the first charging pattern, and it may change the main charging pattern from the first charging pattern to the second charging pattern. For example, the processor 120/320 may apply the first charging pattern (e.g., the main charging pattern) and the obtained data to the life prediction algorithm 312 and predict the life expectancy and the charging time. The processor 120/320 may determine the second charging pattern based on the life expectancy and the charging time. The processor 120/320 may change the main charging pattern from the first charging pattern to the second charging pattern. According to an embodiment, the processor 120/320 may determine the charging current corresponding to the charging voltage of the battery 189 based on the second charging pattern configured as the main charging pattern in response to the charging request signal for the battery 189.

According to an embodiment, the electronic device (e.g., the electronic device 101 of FIGS. 1 and/or 3) may include a battery (e.g., the battery 189 of FIGS. 1 and/or 3), a memory (e.g., the memory 130 of FIGS. 1 and/or 3), and a processor (e.g., the processor 120/320 of FIGS. 1 and/or 3) operatively coupled to the battery and the memory. The processor 120/320 may configure a first charging pattern as the main charging pattern. The processor 120/320 may obtain data related to charging of the battery 189 in a situation in which the battery 189 is charged based on the main charging pattern. The processor 120/320 may identify a first life expectancy based on the configured first charging pattern and the obtained data. The processor 120/320 may identify a second charging pattern that satisfies a second life expectancy relatively longer than the identified first life expectancy. The processor 120/320 may change the main charging pattern from the first charging pattern to the second charging pattern. The processor 120/320 may determine a charging current corresponding to the charging voltage of the battery 189 based on the second charging pattern in response to the charge request signal for the battery 189.

According to an embodiment, the processor 120/320 may identify the first charging time based on the configured first charging pattern and the obtained data and identify the second charging pattern that satisfies a second charging time relatively shorter than the identified first charging time.

According to an embodiment, the processor 120/320 may identify the n-th charging time and n-th life expectancy corresponding to each of the plurality of charging patterns stored in the memory 130. The processor 120/320 may identify the second charging pattern based on the identified n-th charging time and n-th life expectancy.

According to an embodiment, the first charging pattern and the second charging pattern are characterized in that the charging voltage supplied to the battery 189 for each unit charging voltage and the charging current corresponding to the charging voltage supplied for each unit charging voltage are determined.

According to an embodiment, the second charging pattern may include m units of charging sections, the first unit charging section of m units of charging sections may be configured as the first voltage and/or the first current, and the second unit charging section after the first unit charging section may be configured as the second voltage higher than the first voltage and/or the second current higher than the first current.

According to an embodiment, the processor 120/320 may identify at least one charging pattern that satisfies the equivalent circuit model among all charging patterns for charging of the battery 189 and store at least one identified charging pattern in the memory 130.

According to an embodiment, the equivalent circuit model may reflect a configured function and initial resistance based on all charging patterns. According to an embodiment, the processor 120/320, when charging the battery 189 based on at least one charging pattern, may calculate the maximum and/or high capacity of the battery 189 at the time of exceeding the configured number of cycles, and it may store at least one charging pattern in the memory 130 in the case that the calculated maximum and/or high capacity of the battery 189 exceeds the failure capacity ratio of the battery 189.

According to an embodiment, in the operation of charging the battery 189, the data related to the charging of the battery 189 may include at least one of an average current, an average voltage, an average temperature, and/or a history of capacity loss.

According to an embodiment, the processor 120/320 may apply data related to charging of the battery 189 to the life prediction algorithm based on the Bayesian estimation method, and it may identify a first charging time and a first life expectancy corresponding to the first charging pattern based on the life prediction algorithm.

According to an embodiment, the processor 120/320 may identify the n-th charging time and n-th life expectancy corresponding to each of the plurality of charging patterns by applying a life prediction algorithm to each of the charging patterns, generate a "charging time-life expectancy map" corresponding to the plurality of charging patterns based on the identified the n-th charging time and n-th life expectancy, and determine the second charging pattern in which the life expectancy is expected to be relatively long based on the "charging time-life expectancy map".

According to an embodiment, the processor 120/320 may determine the second charging pattern in which the charging time is expected to be relatively shorter than the configured critical charging time based on the "charging time - life expectancy map".

According to an embodiment, the processor 120/320 may delete a charging pattern in which the life expectancy is relatively short while being charged for longer than the critical charging time and a charging pattern in which the life expectancy is relatively long while being charged at a high speed, from the plurality of charging patterns, based on the "charging time-life expectancy map".

According to an embodiment, the processor 120/320 may determine the n'-th charging time and the n'-th life expectancy by applying a life prediction algorithm to each of the plurality of charging patterns included in the "charging time-life expectancy map ". The processor 120/320 may update the "charging time-life expectancy map" corresponding to the plurality of charging patterns based on the identified n'-th charging time and the n'-th life expectancy.

According to an embodiment, the processor 120/320 may identify whether the life expectancy of the battery 189 is improved based on the second charging pattern. The processor 120/320 may divide the unit charging voltage supplying a charging voltage to the battery 189 in the case that the life expectancy of the battery 189 is not improved. The processor 120/320 may supply the charging current based on the divided unit charging voltage.

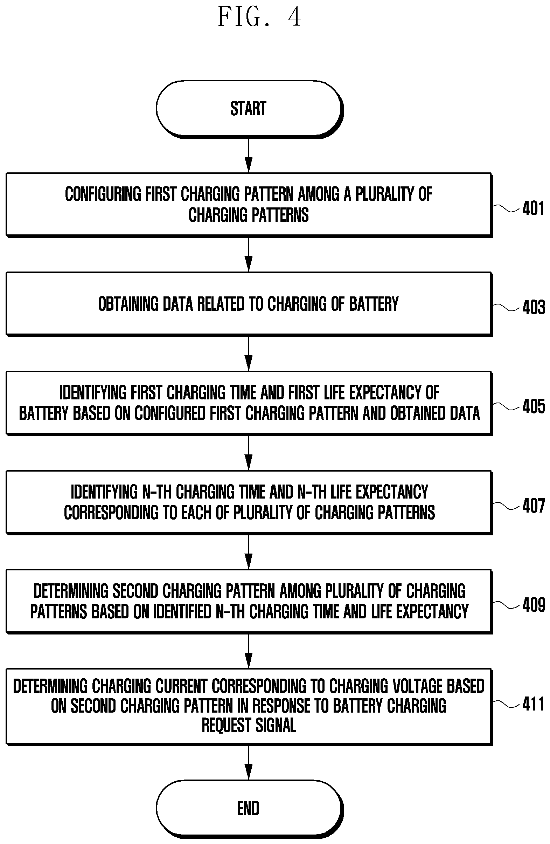

FIG. 4 is a flowchart illustrating a method of determining a charging pattern among a plurality of charging patterns according to an example embodiment.

In the following embodiments, each operation may be performed sequentially, but not necessarily sequentially. For example, the order of each operation may be changed, or at least two operations may be performed in parallel.

The electronic device 101 of FIG. 4 may be at least partially similar to the electronic device 101 of FIG. 1 or may further include other embodiments of the electronic device 101.

In operation 401, the processor (e.g., the processor 120/320 of FIG. 3) of the electronic device 101 may configure the first charging pattern among a plurality of charging patterns as the main charging pattern. For example, the processor 120/320, in charging the battery 189 of FIG. 3, may configure the first charging pattern as the main charging pattern and charge the battery 189 by applying a charging voltage and a charging current to the battery 189 based on the first charging pattern. For example, a plurality of charging patterns may be included in the charging pattern information 311 stored in a memory (e.g., the memory 130 of FIG. 3). According to an embodiment, the processor 120/320 may identify at least one charging pattern that meets the life expectancy based on the Equation 4 by applying Equation 1 to Equation 4 among all charging patterns related to the charging of the battery 189, and at least one identified charging pattern may be stored in the memory 130 as charging pattern information 311.

In operation 403, the processor 120/320 may obtain data related to charging of the battery 189. For example, data related to the charging of the battery 189 may include at least one of an average current, an average voltage, an average temperature, and/or a history of capacity loss, in the previous operation of charging the battery 189. According to an embodiment, the electronic device 101, in the process of charging the battery 189 based on the first charging pattern, may store persistently the data (e.g., an average current, an average voltage, an average temperature, and/or a history of capacity loss) related to charging in the memory 130.

In operation 405, the processor 120/320 may identify a first charging time and a first life expectancy of the battery 189 based on the first charging pattern and the obtained data (e.g., the data related to the charging of the battery 189). According to an embodiment, the processor 120/320 may identify the first charging time and the first life expectancy corresponding to the first charging pattern by applying Equation 6 to Equation 10.

In operation 407, the processor 120/320 may identify the n-th charging time and n-th life expectancy corresponding to each of the plurality of charging patterns included in the charging pattern information 311. For example, the processor 120/320 may identify the charging pattern x corresponding to each of the plurality of charging patterns included in the charging pattern information 311 in the form of ordered pairs using Equation 5. The processor 120/320 may apply the Equation 6 to Equation 10 to each of charging patterns in the form of ordered pairs and identify the n-th charging time and n-th life expectancy corresponding to each charging pattern.

According to an embodiment, the processor 120/320 may identify the second charging pattern that satisfies the second charging time relatively shorter than the identified first charging time and the second life expectancy relatively longer than the identified first life expectancy. For example, the processor 120/320 may identify whether the second charging time is shorter than he first charging time while being shorter than the configured critical charging time based on the first charging time and the second charging time. The processor 120/320 may identify whether the second life expectancy is predicted to be relatively longer than the first life expectancy based on the first life expectancy and the second life expectancy. For example, a charging pattern having a shorter charging time and a longer life expectancy compared to the first charging pattern may be a charging pattern having an improved charging efficiency than the first charging pattern. According to an embodiment, the processor 120/320 may identify the second charging pattern of which the charging efficiency is improved relatively among a plurality of charging patterns.

In operation 409, the processor 120/320 may determine the second charging pattern among the plurality of charging patterns based on the identified n-th charging time and n-th life expectancy. For example, the processor 120/320 may change the main charging pattern configured as the first charging pattern to the second charging pattern. According to an embodiment, the processor 120/320 may identify the charging pattern with the highest life expectancy within the predetermined critical charging time (e.g., t-th) based on the identified n-th charging time and the n-th life expectancy, and it may determine the identified charging pattern as the second charging pattern. For example, the critical charging time (t-th) may include a threshold value for determining the second charging pattern and may be a predetermined fixed value. According to an embodiment, the electronic device 101 may generate and manage a "charging time-life expectancy map" based on the identified n-th charging time and n-th life expectancy. According to an embodiment, the electronic device 101 may continuously update and manage the "charging time-life expectancy map" and select the optimal charging pattern with relatively short charging time and high life expectancy as the process of changing the charging pattern is repeated. In an embodiment, the optimal charging pattern for improving the lifespan (e.g., the life expectancy) of the battery 189 may be determined.

In operation 411, the processor 120/320 may determine the charging current corresponding to the charging voltage of the battery 189 based on the determined second charging pattern in response to a charging request signal for the battery 189. According to an embodiment, the processor 120/320 may charge the battery 189 using the charging voltage and the charging current based on the second charging pattern and improve the life expectancy of the battery 189.

According to an embodiment, the electronic device 101 may configure the cycle period for determining or changing a charging pattern and perform the operation of FIG. 4 in the case that the cycle period is exceeded. For example, the cycle may include the number of times to charge the battery and/or the number of times to discharge the battery. For example, in the case that the cycle for changing or updating the charging pattern is configured to about 50 cycles, the processor 120/320 may identify the first charging time and the first life expectancy based on the currently configured first charging pattern at the time of exceeding about 50 cycles, and it may identify the n-th charging time and the n-th life expectancy corresponding to each of the plurality of charging patterns stored in the memory 130. The processor 120/320 may change the first charging pattern to the second charging pattern based on the identified n-th charging time and n-th life expectancy. According to an embodiment, the cycle period may be changed by configuration.

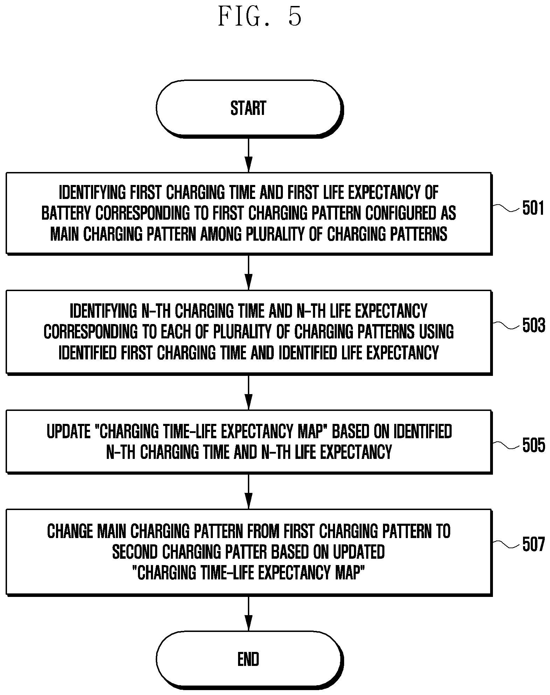

FIG. 5 is a flowchart illustrating a method of updating a charging pattern map for selecting an optimal charging pattern according to an example embodiment.

In the following embodiments, each operation may be performed sequentially, but not necessarily sequentially. For example, the order of each operation may be changed, or at least two operations may be performed in parallel.

The electronic device 101 of FIG. 5 may be at least partially similar to the electronic device 101 of FIG. 1 or may further include other embodiments of the electronic device 101. The flowchart of FIG. 5 may be additional operations included in operations 405 to 409 of FIG. 4.

In operation 501, the processor of the electronic device 101 (e.g., the processor 320 of FIG. 3) may identify a first charging time and a first life expectancy of the battery 189 corresponding to the charging pattern configured as the main charging pattern among a plurality of charging patterns. According to an embodiment, the processor 120/320 may identify a first charging time and a first life expectancy corresponding to the first charging pattern by applying the life prediction algorithm (e.g., the life prediction algorithm 312 of FIG. 3, an algorithm for predicting life expectancy using Equation 6 to Equation 10). For example, the first charging time may indicate the time required to fully charge the battery 189 and the first life expectancy may indicate the life expectancy expressed numerically in the case that the battery 189 is continuously charged.

In operation 503, the processor 120/320 may identify the n-th charging time and the n-th life expectancy corresponding to each of the plurality of charging patterns using the identified first charging time and the first life expectancy. For example, the processor 120/320 may apply the life prediction algorithm 312 in response to the plurality of charging patterns stored in charging pattern information (e.g., the charging pattern information 311 of FIG. 3) and identify an n-th charging time and an n-th life expectancy for each charging pattern.

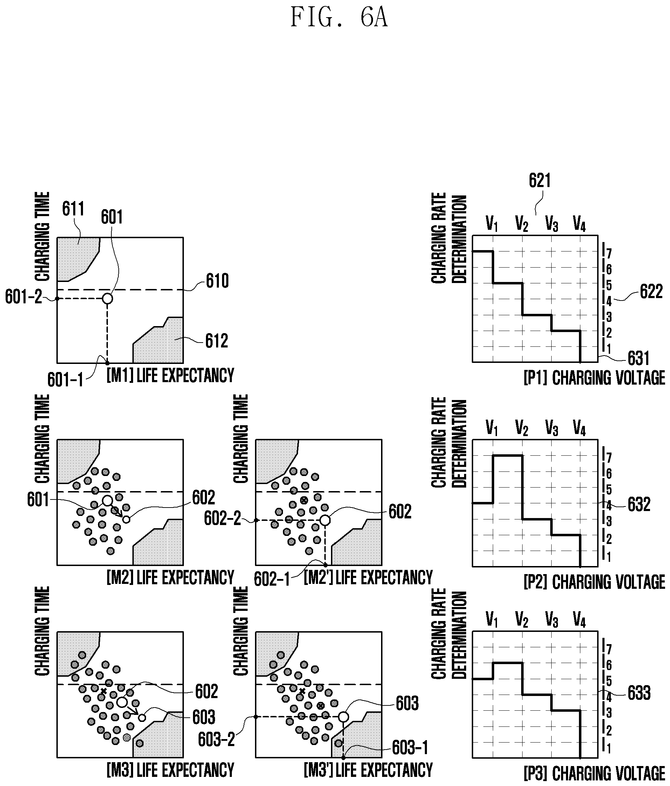

In operation 505, the processor 120/320 may update a "charging time-life expectancy map" based on the identified n-th charging time and n-th life expectancy. For example, the "charging time-life expectancy map" may include a guide map that visually charts the life expectancy and charging time of a specific charging pattern as shown in the graph of M2 in FIG. 6A. According to an embodiment, the electronic device 101 may continuously update and manage the "charging time-life expectancy map", and an optimal charging pattern having a relatively high life expectancy may be selected as the process of changing the charging pattern is repeated. In operation 505, if "charging time-life expectancy map" is not stored in the memory 130, the processor 120/320 may generate a "charging time-life expectancy map" based on the n-th charging time and the n-th life expectancy.

In operation 507, the processor 120/320 may change the main charging pattern from the first charging pattern to the second charging pattern based on the updated "charging time-life expectancy map". For example, in operation 505, the processor 120/320 may determine the second charging pattern in which the life expectancy is expected to be relatively high based on the updated "charging time-life expectancy map" and configure the determined second charging pattern as a main charging pattern.

In an embodiment, the processor 120/320 may determine the charging pattern in which the lifespan (e.g., the life expectancy) of the battery 189 is expected to be improved relatively most and configure the determined charging pattern as the main charging pattern. The processor 120/320 may determine the charging voltage and the charging current supplied to the battery 189 based on the main charging pattern at the time of charging the battery 189.

FIG. 6A is an exemplary diagram illustrating a first embodiment in which a charging pattern is determined among the plurality of charging patterns according to an example embodiment.

The electronic device 101 of FIG. 6A may be at least partially similar to the electronic device 101 of FIG. 1 or may further include other embodiments of the electronic device 101.

With reference to FIG. 6A, three charging patterns (P1 631, P2 632, and P3 633) configured as the main charging pattern are shown and the process of configuring as the main charging pattern is shown. For example, the charging patterns (P1 631, P2 632, and P3 633) may be pattern information in the form that the charging current 622 $I_1, I_2, I_3, I_4, I_5, I_6,$ and $I_7$ is determined corresponding to the charging voltage 621 $V_1, V_2, V_3,$ and $V_4$. For example, in a situation where an electronic device (e.g., the electronic device 101 of FIG. 3) charges a battery (e.g., the battery 189 of FIG. 3) based on a main charging pattern, the first charging voltage V1 may be supplied up to the first charging amount of the battery 189 and the second charging voltage V2 may be supplied up to the second charging amount. The electronic device 101 may configure the charging current supplied per unit charging voltage differently. The charging pattern may include a pattern in which a charging current is determined corresponding to each charging voltage. Examining the firs charging pattern P1 631 of FIG. 6A, for example, the processor (e.g., the processor 320 of FIG. 3) of the electronic device 101 may supply the

fifth charging current $I_5$ to the battery 189 in response to the first charging voltage $V_1$. The processor 120/320 may supply the fifth charging current $I_5$ to the battery 189 until the first charging voltage $V_1$ is changed to the second charging voltage $V_2$. The processor 120/320 may supply a third charging current $I_3$ to the battery 189 in response to the second charging voltage $V_2$ and supply a second charging current $I_2$ in response to the third charging voltage $V_3$. According to an embodiment, the processor 120/320 may determine the charging current corresponding to the charging voltage based on the first charging pattern P1 631 when the first charging pattern P1 631 is configured as the main charging pattern and the battery is charged. According to an embodiment, the charging pattern may not be limited to a rule based on a certain ratio, and the charging current supplied per unit charging voltage may be configured to be higher than before, or lower than the before.

With reference to FIG. 6A, the processor 120/320 of the electronic device 101 may identify the first charging pattern P1 631 configured as the main charging pattern and obtain the data (e.g., an average current, an average voltage, an average temperature, and/or or capacity loss history at the time of charging of the battery 189) related to the charging of the battery 189. According to an embodiment, the processor 120/320 may identify the first charging time 601-2 and the life expectancy 601-1 of the battery 189 based on the first charging pattern P1 631 and the data related to the charging of the battery 189.

With reference to FIG. 6A, a plurality of "charging time-life expectancy maps" M1, M2, M2', M3, and M3' are shown. For example, "charging time-life expectancy map"M1, M2, M2', M3, and M3' may include a graph visually illustrating the "life expectancy" and "charging time" corresponding to specific charging patterns. For example, a critical charging time 610 (e.g., t-th) may be configured in the "charging time-life expectancy map"M1, M2, M2', M3, and M3' and at the time of charging of the battery 189, a charging pattern included within the critical charging time 610 may be included as a charging pattern having a relatively high life expectancy. For example, the "charging time-life expectancy map" M1, M2, M2', M3, and M3' may include an unpredictable area that is difficult to implement electrochemically (e.g., an area 611 with a short life expectancy while being charged at a slow rate and an area 612 with an excessively long life expectancy while being charged at a high rate). For example, the charging pattern included in the unpredictable area may include a charging pattern in which the life expectancy is expected to be short while being charged for longer than the critical charging time 610 and a charging pattern in which the life expectancy is expected to be long while being charged at a high speed. According to an embodiment, the processor 120/320 of the electronic device 101 may predict the "life expectancy" and the "charging time" corresponding to each of the plurality of charging patterns and update the "charging time-life expectancy maps" M1, M2, and M3 based on the predicted "life expectancy" and "charging time". According to an embodiment, if there is no saved "charging time-life expectancy map" M1, M2, and M3, the processor 120/320 may generate a "charging time-life expectancy map".

With reference to FIG. 6A, the processor 120/320 may identify the first charging time 601-2 and the life expectancy 601-1 of the battery 189 based on the first charging pattern P1 631 and the data related to the charging of the battery 189. For example, the processor 120/320 may apply the life expectancy algorithm (e.g., the life expectancy algorithm 312) based on the first charging pattern P1 631 and be indicated as a first point 601 of the first "charging time-life expectancy map" M1. The processor 120/320 may configure the first charging pattern P1 631 as the main configuring pattern. According to an embodiment, the processor 120/320, in the case of charging the battery 189 based the first charging patter P1 631, may require the first charging time 601-2 and predict the first life expectancy 601-1.

According to an embodiment, the processor 120/320 may apply the life prediction algorithm based on each of the plurality of charging patterns included in the charging pattern information 311 of FIG. 3 and be displayed as a second "charging time-life expectancy map" M2. For example, a plurality of points included in the second "charging time-life expectancy map" M2 may include the charging time and the life expectancy corresponding to each of the charging patterns.

According to an embodiment, the processor 120/320 may select a second charging pattern P2 632 corresponding to the second point 602 based on the second "charging time-life expectancy map" M2, and it may configure the selected second charging pattern P2 632 as the main charging pattern. The processor 120/320 may configure the second charging pattern P2 632 corresponding to the second point 602 as the main charging pattern based on the 2-1st "charging time-life expectancy map" M2. For example, the processor 120/320 may supply a seventh charging current $I_7$ to the battery 189 in response to the first charging voltage $V_1$ and supply a third charging current $I_3$ to the battery 189 in response to the second charging voltage $V_2$ based on the second charging pattern P2 632. The processor 120/320 may supply a second charging current $I_2$ to the battery 189 in response to the third charging voltage $V_3$. According to an embodiment, the processor 120/320, in the case that the second charging pattern P2 632 is configured as a main charging pattern, the second charging time 602-2 may be required and the second life expectancy 602-1 may be predicted when the battery 189 is charged.

According to an embodiment, the processor 120/320 may apply the life expectancy algorithm based on each of the plurality of charging patterns (e.g., the plurality of points) included in the second "charging time-life expectancy map" M2, and it may be displayed as a third "charging time-life expectancy map" M3. For example, the processor 120/320 may update the second "charging time-life expectancy map" M2 to the third "charging time-life expectancy map" M3. For example, the plurality of points included in the third "charging time-life expectancy map" M3 may include a charging time and a life expectancy corresponding to each of the charging patterns.

According to an embodiment, the processor 120/320 may select a third charging pattern P3 633 corresponding to the third point 603 based on the third "charging time-life expectancy map" M3, and it may configure the selected third charging pattern P3 633 as the main charging pattern. The processor 120/320 may configure the third charging pattern P3 633 corresponding to the third point 603 as the main charging pattern based on the 3-1st "charging time-life expectancy map" M3'. For example, the processor 120/320 may supply a sixth charging current $I_6$ to the battery 189 in response to the first charging voltage $V_1$ and supply a fourth charging current $I_4$ to the battery 189 in response to the second charging voltage $V_2$ based on the third charging pattern P3 633. The processor 120/320 may supply a third charging current $I_3$ to the battery 189 in response to the third charging voltage $V_3$. According to an embodiment, the processor 120/320, in the case that the third charging pattern P3 633 is configured as a main charging pattern, the third charging time 603-2 may be required and the third life expectancy 603-1 may be predicted when the battery 189 is charged.

According to an embodiment, in a charging pattern (e.g., P1, P2, P3), the m-th voltage and the m-th current supplied to the battery 189 may be configured in response to each unit charging section in a state where the charging voltage is divided into about m unit charging sections. For example, with reference to the second charging pattern P2 632 shown in FIG. 6A, the processor 120/320 may be in a state of supplying the fourth charging current $I_4$ to the battery 189 before the first charging voltage $V_1$ is supplied in the state of being divided into about four unit charging sections. The processor 120/320 may supply the seventh charging current $I_7$ corresponding to the first charging voltage $V_1$ to the battery 189 if the first charging voltage $V_1$ is identified. According to an embodiment, the processor 120/320 may also supply a relatively higher charging current (e.g., the seventh charging current $I_7$) than the previous charging current (e.g., the fourth charging current $I_4$) to the battery 189 in a situation where the unit charging section increases.

According to an embodiment, the processor 120/320 may identify the charging pattern with the highest life expectancy within the predetermined critical charging time (e.g., t-th) based on the "charging time-life expectancy map", and it may determine the identified charging pattern as the main charging pattern. For example, the point where the life expectancy is expected to be the highest may be a point with a relatively highest life expectancy among the shown plurality of points.

Each embodiment herein may be used in combination with any other embodiment(s) described herein.

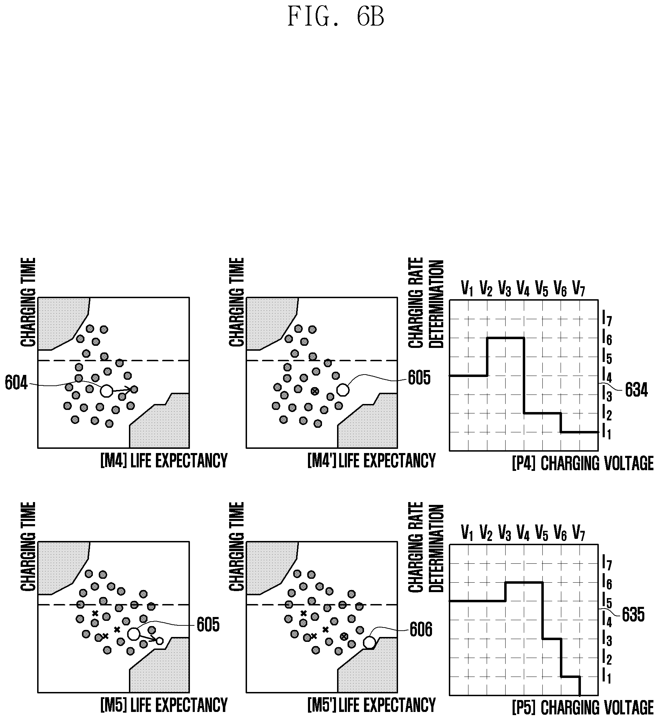

FIG. 6B is an exemplary diagram illustrating a second embodiment in which a charging pattern is determined among the plurality of charging patterns according to an example embodiment.

The electronic device 101 of FIG. 6B may be at least partially similar to the electronic device 101 of FIG. 1 or may further include other embodiments of the electronic device 101.

With reference to FIG. 6B, two charging patterns P4 634 and P5 635 configured as the main charging pattern are shown and the process of configuring as the main charging pattern is shown. With reference to FIG. 6B, two "charging time-life expectancy maps" M4 and M5 are shown.

With reference to FIG. 6B, the processor 120/320 may apply the life prediction algorithm 312 based on each of the plurality of charging patterns stored in charging pattern information (e.g., the charging pattern information 311 of FIG. 3) and predict the fourth "charging time-life expectancy map" M4. For example, the plurality of points included in the fourth "charging time-life expectancy map" M4 may include charging time and life expectancy corresponding to each of the charging patterns. In the fourth "charging time-life expectancy map" M4, the fourth point 604 may be a point corresponding to the main charging pattern.

According to an embodiment, the processor 120/320 may identify the life expectancy corresponding to a specific charging pattern and identify whether the identified life expectancy is substantially higher than the life expectancy according to the main charging pattern. For example, if the life expectancy has improved, the processor 120/320 may change the main charging pattern to the specific charging pattern. For another example, if the life expectancy has not improved, the processor 120/320 may further divide the unit charging voltage and supply the charging voltage and the charging current to the battery 189 based on the divided unit charging voltage. With reference to FIGS. 6A and 6B, in the case of FIG. 6A, the unit charging voltage may be divided into "$V_1$, $V_2$, $V_3$, and $V_4$" and in the case of FIG. 6B, the unit charging voltage may be divided into "$V_1$, $V_2$, $V_3$, $V_4$, $V_5$, $V_6$, and $V_7$".

With reference to FIG. 6B, the processor 120/320 may determine that the life expectancy corresponding to the fourth point 604 has not improved and divide the unit charging voltage additionally. The processor 120/320, in a state in which the unit charging voltage is further divided, may select the fourth charging pattern P4 634 corresponding to the fifth point 605.

According to an embodiment, the processor 120/320 may select the fourth charging pattern P4 634 corresponding to the fifth point 605 based on the fourth "charging time-life expectancy map" M4 and configure the selected fourth charging pattern P4 634 as the main charging pattern. Examining the charging pattern P4 634, the processor 120/320 may provide a fourth charging current $I_4$ to the battery 189 corresponding to the first charging voltage $V_1$ to the second charging voltage $V_2$ range. Th processor 120/320 may provide a sixth charging current $I_6$ to the battery 189 corresponding to the second charging voltage $V_2$ to the fourth charging voltage $V_4$ range. The processor 120/320 may provide a second charging current $I_2$ to the battery 189 corresponding to the fourth charging voltage $V_4$ to the sixth charging voltage $V_6$

range. The processor 120/320 may provide a first charging current $I_1$ to the battery 189 corresponding to the sixth charging voltage $V_6$ to the seventh charging voltage $V_7$. According to an embodiment, the processor 120/320 may determine a charging current corresponding to the charging voltage depending on the unit charging voltage based on the fourth charging pattern P4 634 when charging the battery 189 in the case that the fourth pattern P4 634 is configured as the main charging pattern. According to an embodiment, the processor 120/320 may increase the fourth charging current $I_4$ to the sixth charging current $I_6$ and supply the increased sixth charging current $I_6$ to the battery 189 in the situation that the unit charging section increases from the first charging voltage $V_1$ to the second charging voltage $V_2$ range (e.g., the first charging section) to the second charging voltage $V_2$ to the fourth charging voltage $V_4$ range (e.g., the second charging section).

According to an embodiment, the processor 120/320 may determine whether the life expectancy of the battery 189 is substantially improved based on the fourth charging pattern P4 634 configured as the main charging pattern. For example, the processor 120/320 may predict a life expectancy corresponding to each of the plurality of charging patterns and determine whether the life expectancy corresponding to the charging pattern P4 634 is predicted to be relatively longer. A fifth "charging time-life expectancy map" M5 of FIG. 6B illustrates a charging time and a life expectancy corresponding to each of the plurality of charging patterns.

According to an embodiment, if the predicted life expectancy of the electronic device 101 does not improve, the unit charging voltage may be further divided based on the plurality of charging patterns included in the charging pattern information 311, and a new "charging time-life expectancy map" (e.g., a fifth "charging time-life expectancy map" M5 of FIG. 6B) may be created based on the divided unit charging voltage.

With reference to FIG. 6B, the processor 120/320, based on the unit charging voltage divided into 7 sections (e.g., "$V_1,V_2,V_3,V_4,V_5,V_6,V_7$"), may identify a fifth "charging time-life expectancy map" M5 corresponding to a plurality of charging patterns. The processor 120/320, based on the fifth "charging time-life expectancy map" M5, may determine a charging pattern that takes a relatively short charging time while providing a relatively long life expectancy. For example, the processor 120/320 may change the main charging pattern from the fourth charging pattern P4 634 to the fifth charging pattern P5 635 corresponding to the sixth point 606 in relation to the fourth charging pattern P4 634 configured as the main charging pattern corresponding to the fifth point 605.

According to an embodiment, the processor 120/320 may identify the fifth "charging time-life expectancy map" M5 generated based on a fifth unit charging voltage divided into seven unit charging sections (e.g., $V_1,V_2,V_3,V_4,V_5,V_6,V_7$") and change the main configuring pattern from the fifth point 605 to the sixth point 606. The processor 120/320 may select a fifth charging pattern P5 635 corresponding to the sixth point 606 configured as the main configuration pattern. For example, the fifth charging pattern P5 635 may have a relatively short charging time and relatively long life expectancy compared to the fourth charging pattern P4 634.

Examining the charging pattern P5 635, the processor 120/320 may provide a fifth charging current $I_5$ to the battery 189 from the first charging voltage $V_1$ to the third charging voltage $V_3$ and provide a sixth charging current $I_6$ to the battery 189 from the third charging voltage $V_3$ to the fifth charging voltage $V_5$. The processor 120/320 may provide a third charging current $I_3$ to the battery 189 from the fifth charging voltage $V_5$ to the sixth charging voltage $V_6$ and provide a first charging current $I_1$ to the battery 189 corresponding to the sixth charging voltage $V_6$ to the seventh charging voltage $V_7$.

In an embodiment, the processor 120/320 may determine the charging pattern (e.g., the charging pattern in which the charging time is reduced, and the life expectancy is increased) in which the lifespan (e.g., the life expectancy) of the battery 189 is expected to be improved relatively most and configure the determined charging pattern as the main charging pattern. In an embodiment, if the processor 120/320 determines that the life expectancy of the battery 189 is no longer improving, the points included in the existing "charging time-life expectancy map" may no longer be considered. The processor 120/320 may generate a new "charging time-expectancy map" by applying a method (e.g., the changed method of the unit charging voltage division method) in which the unit charging voltage is additionally divided.

In a method of charging the battery (e.g., the battery 189 of FIG. 1 and/or FIG. 3) according to an embodiment, a first charging pattern may be configured as the main charging pattern. The method according to an embodiment may obtain data related to charging of the battery 189 in a situation in which the battery 189 is charged based on the main charging pattern. The method according to an embodiment may identify a first life expectancy based on the configured first charging pattern and the obtained data. The method according to an embodiment may identify a second charging pattern that satisfies a second life expectancy relatively longer than the identified first life expectancy. The method according to an embodiment may change the main charging pattern from the first charging pattern to the second charging pattern. The method according to an embodiment may determine a charging current corresponding to the charging voltage of the battery 189 based on the second charging pattern in response to the charge request signal for the battery 189.

The method according to an embodiment, based on the configured first charging pattern and the obtained data, may further include an operation of identifying the first charging time and an operation of identifying a second charging pattern that satisfies a second charging time that is relatively shorter than the identified first charging time.

The operation of identifying the second charging pattern according to an embodiment may identify the n-th charging time and the n-th life expectancy corresponding to each of the plurality of charging patterns stored in the memory (e.g., the memory of FIG. 1 and/or FIG. 3) and identify the second charging pattern based on the identified n-th charging time and the n-th life expectancy.

According to an embodiment, the first charging pattern and the second charging pattern may include the charging pattern in which the charging voltage supplied to the battery 189 by the unit charging voltage and the charging current corresponding to the supplied charging voltage by the unit charging voltage are determined. According to an embodiment, the second charging pattern may include m units of charging sections. The first unit charging section of m units of charging sections may be configured as the first voltage and/or the first current, and the second unit charging section after the first unit charging section may be configured as the second voltage higher than the first voltage and/or the second current higher than the first current.

The method according to an embodiment may include further the operation of applying the data related to charging of the battery 189 to the life prediction algorithm based on Bayesian estimation method and the operation of identifying the first charging time and the first life expectancy corresponding to the first charging pattern based on the life prediction algorithm.

The method according to an embodiment may include further an operation of identifying the n-th charging time and the life expectancy by applying the life prediction algorithm to each of the plurality of charging patterns; an operation of generating the "charging time-life expectancy map" corresponding to a plurality of charging patterns based on the identified the n-th charging time and the n-th life expectancy; and an operation of determining the second charging pattern in which the life expectancy is expected to be relatively long based on the "charging time-life expectancy map".

The operation of determining the second charging pattern according to an embodiment may include an operation of determining a second charging pattern expected to be relatively shorter than a predetermined threshold charging time based on a "charging time-life expectancy map".

The method according to an embodiment may include further an operation of identifying the n'-th charging time and the n'-th life expectancy by applying the life prediction algorithm to each of the plurality of the charging patterns included in the "charging time-life expectancy map" and an operation of updating the "charging time-life expectancy map" corresponding to the plurality of charging patterns based on the identified n'-th charging time and the identified n'-th life expectancy.

The method according to an embodiment may include further an operation of identifying whether the life expectancy of the battery 189 is improved based on the second charging pattern, and an operation of dividing the unit charging voltage supplying a charging voltage to the battery 189 in the case that the life expectancy of the battery 189 is not improved, and an operation of supplying the charging current based on the divided unit charge voltage.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. It is intended that features described with respect to separate embodiments, or features recited in separate claims, may be combined unless such a combination is explicitly specified as being excluded or such features are incompatible. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via at least a third element(s).

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an applicationspecific integrated circuit (ASIC). Thus, each "module" herein may comprise circuitry.

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120/320) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various embodiments, it will be understood that the various embodiments are intended to be illustrative, not limiting. It will further be understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

**Claims**

1. An electronic device comprising:

   a battery;
   a memory storing a first charging pattern as a main charging pattern; and
   a processor operatively coupled to the battery and the memory, wherein the processor is configured to:

      obtain data related to charging of the battery in a situation where the battery is charged based on the main charging pattern,
      identify a first life expectancy based on the configured first charging pattern and the obtained data,
      identify a second charging pattern that satisfies a second life expectancy relatively longer than the identified first life expectancy,
      change the main charging pattern from the first charging pattern to the second charging pattern, and
      determine a charging current corresponding to a charging voltage of the battery based on the second charging pattern in response to a charging request signal.

2. The electronic device of claim 1, wherein
   the processor is configured to:

      identify a first charging time based on the first charging pattern and the obtained data, and
      identify the second charging pattern that satisfies a second charging time relatively shorter than the identified first charging time.

3. The electronic device of claim 1, wherein

the processor is configured to identify an n-th charging time and an n-th life expectancy corresponding to each of a plurality of charging patterns stored in the memory, and
identify the second charging pattern based on the identified n-th charging time and the n-th life expectancy.

4. The electronic device of claim 1,

wherein the first charging pattern and the second charging pattern include respective patterns in which the charging voltage supplied to the battery by a unit charging voltage and the charging current corresponding to the charging voltage supplied by the unit charging voltage are determined,
wherein the second charging pattern includes m unit charging sections,
a first unit charging section of the m unit charging sections is configured with a first voltage and/or a first current, and
a second unit charging section of the m unit charging sections, after the first unit charging section, is configured with a second voltage higher than the first voltage and a second current higher than the first current.

5. The electronic device of claim 1, wherein
the processor is configured to:

identify at least one charging pattern that satisfies an equivalent circuit model among charging patterns for charging the battery, and
store the at least one identified charging pattern in the memory.

6. The electronic device of claim 5, wherein

the equivalent circuit model reflects a configured function and initial resistance based on the charging patterns for charging the batter, and
the processor is configured to, when charging the battery based on the at least one charging pattern, calculate a maximum and/or high capacity of the battery at a time of exceeding a configured number of cycles and store at least one charging pattern in the memory in a case that the calculated maximum and/or high capacity of the battery exceeds a failure capacity ratio of the battery.

7. The electronic device of claim 1, wherein
the processor is configured to:

apply the data related to the charging of the battery to a life prediction algorithm based on Bayesian estimation, and
identify a first charging time and the first life expectancy corresponding to the first charging pattern based on the life prediction algorithm.

8. The electronic device of claim 7, wherein the processor is configured to:

identify an n-th charging time and an n-th life expectancy at least by applying the life prediction algorithm to each of a plurality of charging patterns,
generate a charging time-life expectancy map corresponding to the plurality of charging patterns based on the identified n-th charging time and the identified n-th life expectancy, and
determine the second charging pattern in which the life expectancy is expected to be relatively long based on the charging time-life expectancy map.

9. The electronic device of claim 8, wherein
the processor is configured to determine the second charging pattern, which is expected to be shorter than a critical charging time, based on the charging time-life expectancy map.

10. The electronic device of claim 9, wherein the processor is configured to:

identify the n'-th charging time and the n'-th life expectancy at least by applying the life prediction algorithm to each of a plurality of charging patterns included in the charging time-life expectancy map, and
update the charging time-life expectancy map corresponding to the plurality of charging patterns based on the identified n'-th charging time and the n'-th life expectancy.

EP 4 542 817 A1

11. The electronic device of claim 1, wherein the processor is configured to:

identify whether life expectancy of the battery is improved based on the second charging pattern,
divide a unit charging voltage supplying the charging voltage to the battery, to provide a divided unit charging voltage, in a case that the life expectancy of the battery is not improved, and
supply the charging current based on the divided unit charging voltage.

12. A method for an electronic device to charge a battery, the method comprising:

configuring a first charging pattern as a main charging pattern;
obtaining data related to charging of the battery in a situation in which the battery is charged based on the main charging pattern;
identifying a first life expectancy based on the first charging pattern and the obtained data;
identifying a second charging pattern that satisfies a second life expectancy relatively longer than the identified first life expectancy;
changing the main charging pattern from the first charging pattern to the second charging pattern; and
determining a charging current corresponding to a charging voltage of the battery based on the second charging pattern in response to a charging request signal.

13. The method of claim 12, further comprising identifying a first charging time based on the first charging pattern and the obtained data, and
identifying the second charging pattern that satisfies a second charging time relatively shorter than the identified first charging time.

14. The method of claim 12, wherein
identifying the second charging pattern comprises identifying an n-th charging time and an n-th life expectancy corresponding to each of a plurality of charging patterns stored in memory and identifying the second charging pattern based on the identified n-th charging time and the n-th life expectancy.

15. The method of claim 12, wherein

the first charging pattern and the second charging pattern comprise a pattern in which a charging voltage supplied to the battery for each charging voltage and a charging current corresponding to the charging voltage supplied for each unit charging voltage are determined;
the second charging pattern comprises m unit charging sections;
a first unit charging section of the m unit charging sections is configured with the first voltage and/or a first current; and
a second unit charging section of the m unit charging sections, after the first unit charging section, is configured with a second voltage higher than the first voltage and a second current higher than the first current.

# FIG. 1

ELECTRONIC DEVICE 101

INPUT MODULE 150

SOUND OUTPUT MODULE 155

BATTERY 189

POWER MANAGEMENT MODULE 188

AUDIO MODULE 170

HAPTIC MODULE 179

DISPLAY MODULE 160

PROCESSOR 120
- MAIN PROCESSOR 121
- AUXILIARY PROCESSOR 123

SENSOR MODULE 176

CAMERA MODULE 180

MEMORY 130
- VOLATILE MEMORY 132
- NON-VOLATILE MEMORY 134
  - INTERNAL MEMORY 136
  - EXTERNAL MEMORY 138

COMMUNICATION MODULE 190
- WIRELESS COMMUNICATION MODULE 192
- WIRED COMMUNICATION MODULE 194

SUBSCRIBER IDENTIFICATION MODULE 196

ANTENNA MODULE 197

INTERFACE 177

CONNECTION TERMINAL 178

PROGRAM 140
- APPLICATION 146
- MIDDLE WARE 144
- OPERATING SYSTEM 142

100

SECOND NETWORK 199

FIRST NETWORK 198

ELECTRONIC DEVICE 104

ELECTRONIC DEVICE 102

SERVER 108

EP 4 542 817 A1

FIG. 2

200

188

189

POWER MANAGEMENT MODULE

CHARGING CIRCUIT — 210

POWER REGULATOR — 220

FUEL GAUGE — 230

BATTERY

BATTERY PROTECTION CIRCUIT — 240

# FIG. 3

# FIG. 4

START

CONFIGURING FIRST CHARGING PATTERN AMONG A PLURALITY OF CHARGING PATTERNS ⌇~401

OBTAINING DATA RELATED TO CHARGING OF BATTERY ⌇~403

IDENTIFYING FIRST CHARGING TIME AND FIRST LIFE EXPECTANCY OF BATTERY BASED ON CONFIGURED FIRST CHARGING PATTERN AND OBTAINED DATA ⌇~405

IDENTIFYING N-TH CHARGING TIME AND N-TH LIFE EXPECTANCY CORRESPONDING TO EACH OF PLURALITY OF CHARGING PATTERNS ⌇~407

DETERMINING SECOND CHARGING PATTERN AMONG PLURALITY OF CHARGING PATTERNS BASED ON IDENTIFIED N-TH CHARGING TIME AND LIFE EXPECTANCY ⌇~409

DETERMINING CHARGING CURRENT CORRESPONDING TO CHARGING VOLTAGE BASED ON SECOND CHARGING PATTERN IN RESPONSE TO BATTERY CHARGING REQUEST SIGNAL ⌇~411

END

# FIG. 5

START

IDENTIFYING FIRST CHARGING TIME AND FIRST LIFE EXPECTANCY OF BATTERY CORRESPONDING TO FIRST CHARGING PATTERN CONFIGURED AS MAIN CHARGING PATTERN AMONG PLURALITY OF CHARGING PATTERNS — 501

IDENTIFYING N-TH CHARGING TIME AND N-TH LIFE EXPECTANCY CORRESPONDING TO EACH OF PLURALITY OF CHARGING PATTERNS USING IDENTIFIED FIRST CHARGING TIME AND IDENTIFIED LIFE EXPECTANCY — 503

UPDATE "CHARGING TIME-LIFE EXPECTANCY MAP" BASED ON IDENTIFIED N-TH CHARGING TIME AND N-TH LIFE EXPECTANCY — 505

CHANGE MAIN CHARGING PATTERN FROM FIRST CHARGING PATTERN TO SECOND CHARGING PATTER BASED ON UPDATED "CHARGING TIME-LIFE EXPECTANCY MAP" — 507

END

# FIG. 6A

# FIG. 6B

<div align="center">**INTERNATIONAL SEARCH REPORT**</div>

| | International application No. |
|---|---|
| | **PCT/KR2023/014363** |

**A. CLASSIFICATION OF SUBJECT MATTER**

**H02J 7/00**(2006.01)i; **G01R 31/382**(2019.01)i; **G01R 31/392**(2019.01)i; **H01M 10/44**(2006.01)i

According to International Patent Classification (IPC) or to both national classification and IPC

**B. FIELDS SEARCHED**

Minimum documentation searched (classification system followed by classification symbols)

H02J 7/00(2006.01); G01R 31/382(2019.01); G06F 1/32(2006.01); H01M 10/48(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전 패턴(charging pattern), 충전 전압(charging voltage), 충전 시간(charging time), 기대 수명(life expectancy)

**C. DOCUMENTS CONSIDERED TO BE RELEVANT**

| Category* | Citation of document, with indication, where appropriate, of the relevant passages | Relevant to claim No. |
|---|---|---|
| X | US 2018-0321730 A1 (SAMSUNG ELECTRONICS CO., LTD.) 08 November 2018 (2018-11-08)<br>See paragraphs [0029], [0033] and [0043]; claims 10 and 14; and figure 1. | 1-2,12-13 |
| A | KR 10-1794847 B1 (FOUNDATION OF SOONGSIL UNIVERSITY-INDUSTRY COOPERATION) 07 November 2017 (2017-11-07)<br>See claim 1. | 1-2,12-13 |
| A | KR 10-2013-0080302 A (LG ELECTRONICS INC.) 12 July 2013 (2013-07-12)<br>See claims 1-3. | 1-2,12-13 |
| A | WO 2016-076646 A1 (SAMSUNG ELECTRONICS CO., LTD.) 19 May 2016 (2016-05-19)<br>See claim 1. | 1-2,12-13 |
| A | KR 10-2022-0017584 A (SAMSUNG ELECTRONICS CO., LTD.) 14 February 2022 (2022-02-14)<br>See claim 1. | 1-2,12-13 |

☐ Further documents are listed in the continuation of Box C.     ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **22 December 2023** | **26 December 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2023/014363**

| Box No. II | Observations where certain claims were found unsearchable (Continuation of item 2 of first sheet) |
|---|---|

This international search report has not been established in respect of certain claims under Article 17(2)(a) for the following reasons:

1. ☐   Claims Nos.:
   because they relate to subject matter not required to be searched by this Authority, namely:

2. ☐   Claims Nos.:
   because they relate to parts of the international application that do not comply with the prescribed requirements to such an extent that no meaningful international search can be carried out, specifically:

3. ☑   Claims Nos.: **3-11, 14-15**
   because they are dependent claims and are not drafted in accordance with the second and third sentences of Rule 6.4(a).

Form PCT/ISA/210 (continuation of first sheet) (July 2022)

**INTERNATIONAL SEARCH REPORT**
**Information on patent family members**

International application No.

**PCT/KR2023/014363**

| Patent document cited in search report | | | Publication date (day/month/year) | Patent family member(s) | | | Publication date (day/month/year) |
|---|---|---|---|---|---|---|---|
| US | 2018-0321730 | A1 | 08 November 2018 | None | | | |
| KR | 10-1794847 | B1 | 07 November 2017 | None | | | |
| KR | 10-2013-0080302 | A | 12 July 2013 | KR | 10-1303164 | B1 | 09 September 2013 |
| WO | 2016-076646 | A1 | 19 May 2016 | CN | 105610213 | A | 25 May 2016 |
| | | | | CN | 105610213 | B | 07 August 2020 |
| | | | | CN | 111817390 | A | 23 October 2020 |
| | | | | CN | 111817391 | A | 23 October 2020 |
| | | | | EP | 3021452 | A1 | 18 May 2016 |
| | | | | EP | 3767782 | A1 | 20 January 2021 |
| | | | | KR | 10-2016-0057091 | A | 23 May 2016 |
| | | | | KR | 10-2336856 | B1 | 08 December 2021 |
| | | | | US | 2016-0141893 | A1 | 19 May 2016 |
| | | | | US | 9853476 | B2 | 26 December 2017 |
| KR | 10-2022-0017584 | A | 14 February 2022 | US | 2023-0179008 | A1 | 08 June 2023 |
| | | | | WO | 2022-030912 | A1 | 10 February 2022 |

Form PCT/ISA/210 (patent family annex) (July 2022)